# EUROPEAN PATENT SPECIFICATION

(11) **EP 3 771 039 B1**
(45) Date of publication and mention of the grant of the patent: **17.04.2024**
(21) Application number: 19772003.0
(22) Date of filing: 20.03.2019
(51) Int. Cl.: H01Q 17/00, H05K 9/00

(54) **LAMBDA/4 TYPE RADIO WAVE ABSORBER**
ABSORBER VON LAMBDA/4-FUNKWELLEN
ABSORBEUR D'ONDES RADIO DE TYPE LAMBDA /4

(30) Priority: 20.03.2018 JP 2018052716
(43) Date of publication of application: 27.01.2021
(73) Proprietor: Sekisui Chemical Co., Ltd., Osaka-shi, Osaka 530-0047 (JP)
(72) Inventor: NAKAO, Sachiko, Gamagori-shi, Aichi 443-0036 (JP); MUTOU, Katsunori, Gamagori-shi, Aichi 443-0036 (JP); SAWADAISHI, Tetsuro, Gamagori-shi, Aichi 443-0036 (JP)
(74) Representative: Cabinet Beau de Loménie
(86) International application number: PCT/JP2019/011664
(87) International publication number: WO 2019/182002

(56) References cited:
- WO-A1-2017/104711
- JP-A- 2017 208 407
- JP-A- 2018 056 562
- US-A1- 2009 084 994
- US-A1- 2010 090 879
- US-A1- 2010 090 879
- US-B1- 6 650 478

## Description

### TECHNICAL FIELD

The present invention relates to a λ/4 type radio wave absorber having excellent durability.

### BACKGROUND ART

Portable communication devices such as mobile phones or smartphones have rapidly spread in recent years. Also, many electronic devices are now mounted on automobiles or the like. These devices generate radio waves or noise to often problematically cause radio disturbance or malfunctions in other electronic devices. Various radio wave absorbers are now considered as means to prevent such radio disturbance or malfunctions. For example, JP H05 114813 A discloses a λ/4 type radio wave absorber including a dielectric spacer having a thickness of substantially λ/4 (λ represents a wavelength of a radio wave in a dielectric), a complete reflector mounted on the rear surface of the dielectric spacer, and a resistive film formed by ion plating, vapor deposition, sputtering or the like on the front surface of the dielectric spacer.

According to US 6, 650, 478 B1, an optical filter contains a unique combination of an interfering Fabry-Perot stack and a massive Fabry-Perot stack, which filter includes an infrared reflecting metal layer on a stack having first and second absorbing metal layers alternatively with first and second dielectric metal layers.

An electromagnetic wave absorber of WO 2017/104711 A1 sandwiches a dielectric layer between a resistor and a conductor layer and has outermost resin layers.

US 2009/0084994 A1 shows a method for reducing electromagnetic interference, and radio frequency interference within an enclosure having transparent areas, the method comprising the step of applying an optically transparent filter to said transparent areas, said filter comprising an electrically conductive metal layer, said combination of filters being configured to prevent or attenuate the passage of the electromagnetic interference and radio frequency interference through the transparent areas.

In a radio wave absorber which absorbs radio waves arriving from one side and does no transmit it to the other side, a support layer, a barrier layer containing a metal oxide, a radio wave absorbing layer configured to absorb a predetermined radio wave, an adhesive layer, and a base layer are arranged from one side according to JP 2017-208407 A.

US 2010/0090870 A1 shows a λ/4 type radio wave absorber according to the preamble of claim 1.

### SUMMARY OF INVENTION

### - Technical Problem

Conventional λ/4 type radio wave absorbers have a structure in which an indium tin oxide (ITO) film as a resistive film, a dielectric, and a conductive layer made of aluminum or the like are laminated. This ITO film is often formed on a polymer film such as a polyethylene terephthalate (PET) film for reducing the cost. Since polymer films cannot be heated at high temperature, the ITO film cannot be formed under heating. The film formed is therefore amorphous. Amorphous films have high resistivity and poor durability or chemical stability in the air. The formed ITO film is therefore commonly annealed in the post-process for crystallization, thereby improving the physical properties thereof.

However, since polymer films cannot endure high annealing temperatures, annealing needs to be performed at a relatively low temperature for a long time, e.g. , at 140°C for 1 hour. If a metal film that needs no annealing can be used as a resistive film instead of an ITO film, no annealing is required after film formation, which expectedly leads to significant improvement in productivity and significant cost reduction. Also, since ITO contains much indium that is a metal whose estimated consumption is greater than its reserves, exhaustion of indium is concerned. In view of this, development of a resistive film material that can replace ITO is awaited.

Many metal films however have poor durability in the air when used as a resistive film having a 376.7 Ω/□ in a λ/4 type radio wave absorber, and the radio wave absorbability of the λ/4 type radio wave absorber is problematically reduced over time. Resistive films for λ/4 type radio wave absorbers must have a surface resistance value of 376.7Ω/□ ± 10%.

In view of the state of the art, the present invention aims to provide a λ/4 type radio wave absorber having excellent durability.

### - Solution to problem

The present invention is defined in the claims and specifically described in the following.

A reason why a λ/4 type radio wave absorber including a metal film as a resistive film has poor durability is that the surface resistance value of the resistive film included in the λ/4 type radio wave absorber significantly varies over time and such variation is partially responsible for reduction in the radio wave absorbability.

Various metals have been studied as a metal to be used for a resistive film in a λ/4 type radio wave absorber instead of ITO, including stainless steel (iron-chromium alloy, SUS), alloys such as nickel-chromium alloy, and titanium. For example, in cases where SUS or nickel-chromium alloy is used for a resistive film, a passive film having a thickness of 10 nm or less is formed on the surface of the resistive film, leading to stabilization. However, if such a resistive film is left to stand, a salt content (chlorine ion) in the air is attached to the surface to break down the passive film and to damage the resistive film itself, presumably resulting in variation in the surface resistance value. In cases where titanium is used for a resistive film, a titanium film satisfying the surface resistance value of 376.7 Ω/□ is as thin as about 1 nm. If such a resistive film is left to stand, titanium therein is oxidized due to oxygen in the air and is substituted with titanium oxide from the surface of the film, resulting in variation in the surface resistance value.

A resistive film made of an alloy containing molybdenum suffers less variation in the surface resistance value even in the case of being left to stand in the air and enables production of a λ/4 type radio wave absorber having excellent durability

The λ/4 type radio wave absorber of the present invention as defined in claim 1 includes a resistive film containing molybdenum, a dielectric layer, and a reflective layer, in the stated order. In other words, the λ/4 type radio wave absorber of the present invention has a multilayer structure including a resistive film, a dielectric, and a reflective layer laminated in the stated order. Other layer(s) such as an adhesive layer may be provided between the resistive film and the dielectric and between the dielectric and the reflective layer. A λ/4 type radio wave absorber can be obtained by arranging a resistive film and a reflective layer to be distant from each other by λ/4 with a dielectric layer interposed therebetween. The presence of molybdenum in the resistive film reduces variation in the surface resistance value of the resistive film left to stand in the air, so that the λ/4 type radio wave absorber can have excellent durability. The reason why the durability is improved is not limited to this theory but the presence of molybdenum presumably contributes to improvement of the corrosion resistance not only under an acidic atmosphere but also under a reducing atmosphere. Here, λ refers to the wavelength of the radio wave in the dielectric.

The lower limit of the amount of the molybdenum is not limited. Yet, in view of further improving the durability, the lower limit is preferably 5% by weight, more preferably 7% by weight, still more preferably 9% by weight, further more preferably 11% by weight, particularly preferably 13% by weight, significantly preferably 15% by weight, most preferably 16% by weight. The upper limit of the amount of the molybdenum is 30% by weight, preferably 25% by weight, more preferably 20% by weight in view of facilitating control of the surface resistance value.

The resistive film contains the molybdenum. Yet, the resistive film preferably further contains nickel and chromium.

The resistive film containing nickel and chromium in addition to molybdenum can impart further excellent durability to the λ/4 type radio wave absorber. Examples of an alloy containing nickel, chromium, and molybdenum include various grades of HASTELLOY such as B-2, B-3, C-4, C-2000, C-22, C-276, G-30, N, W, and X.

In cases where the resistive film contains molybdenum, nickel, and chromium, preferably, the amount of molybdenum is 5% by weight or more, the amount of nickel is 40% by weight or more, and the amount of chromium is 1% by weight or more. With the amounts of molybdenum, nickel, and chromium within the above ranges, the λ/4 type radio wave absorber can have further excellent durability. More preferably, the amount of molybdenum is 7% by weight or more, the amount of nickel is 45% by weight or more, and the amount of chromium is 3% by weight or more. Still more preferably, the amount of molybdenum is 9% by weight or more, the amount of nickel is 47% by weight or more, and the amount of chromium is 5% by weight or more. Further more preferably, the amount of molybdenum is 11% by weight or more, the amount of nickel is 50% by weight or more, and the amount of chromium is 10% by weight or more. Particularly preferably, the amount of molybdenum is 13% by weight or more, the amount of nickel is 53% by weight or more, and the amount of chromium is 12% by weight or more. Significantly preferably, the amount of molybdenum is 15% by weight or more, the amount of nickel is 55% by weight or more, and the amount of chromium is 15% by weight or more. Most preferably, the amount of molybdenum is 16% by weight or more, the amount of nickel is 57% by weight or more, and the amount of chromium is 16% by weight or more.

The amount of nickel is preferably 80% by weight or less, more preferably 70% by weight or less, still more preferably 65% by weight or less . The upper limit of the amount of chromium is preferably 50% by weight or less, more preferably 40% by weight or less, still more preferably 35% by weight or less.

Examples of metals contained in the resistive film in addition to molybdenum, nickel, and chromium include iron, cobalt, tungsten, manganese, and titanium. In cases where the resistive film contains molybdenum, nickel, and chromium, the upper limit of the amount in total of the metals other than molybdenum, nickel, and chromium in view of the durability of the resistive film is preferably 45% by weight, more preferably 40% by weight, still more preferably 35% by weight, further more preferably 30% by weight, particularly preferably 25% by weight, significantly preferably 23% by weight. The lower limit of the amount in total of the metals other than molybdenum, nickel, and chromium is, for example, 1% by weight or more.

In cases where the resistive film contains iron, the upper limit of the amount thereof in view of the durability of the resistive film is preferably 25% by weight, more preferably 20% by weight, still more preferably 15% by weight and the lower limit thereof is preferably 1% by weight. In cases where the resistive film contains cobalt and/or manganese, the upper limits of the amounts thereof in view of the durability of the resistive film are each independently preferably 5% by weight, more preferably 4% by weight, still more preferably 3% by weight and the lower limits thereof are preferably each independently 0.1% by weight. In cases where the resistive film contains tungsten, the upper limit of the amount thereof in view of the durability of the resistive film is preferably 8% by weight, more preferably 6% by weight, still more preferably 4% by weight and the lower limit thereof is preferably 1% by weight.

The resistive film may contain silicon and/or carbon. In cases where the resistive film contains silicon and/or carbon, the amounts thereof are each independently preferably 1% by weight or less, more preferably 0.5% by weight or less. In cases where the resistive film contains silicon and/or carbon, the amounts thereof are each independently preferably 0.01% by weight or more.

The amounts can be measured by X-ray photoelectron spectroscopy (XPS).

More specifically, the XPS spectrum of the surface is measured using (PHI5000 VersaProbeII available from Ulvac-Phi, Incorporated, or its equivalent) and a monochromatic AlKα X-ray source (1486.6 eV) at an Ar ion accelerating voltage of 1 kV.

The resistive film may have a substrate. The substrate may be a resin film. Examples of the resin film include polyolefin films such as polyethylene films and polypropylene films, polyester films such as polyethylene terephthalate films and polyethylene naphthalate films, and polyurethane films. The substrate film may have any thickness, and the thickness is, for example, 10 to 300 µm.

The dielectric may be any dielectric. The dielectric may be a conventionally known dielectric used in λ/4 type radio wave absorbers, such as organic foam, an organic polymer sheet, or an organic polymer film. The thickness of the dielectric layer is one-fourth of the wavelength of the radio wave in the dielectric used for the dielectric layer.

The reflective layer may be made of any material, and a conventionally known radio wave reflection film used for λ/4 type radio wave absorbers may be used. Examples of a electromagnetic wave reflection film include metal films (e.g., aluminum film, copper film, silver film, iron film) and metal compound films (e.g., ITO film) . The reflective layer may have any thickness. The lower limit of the thickness is preferably 0.1 mm and the upper limit thereof is preferably 2.0 mm.

The λ/4 type radio wave absorber of the present invention has a barrier layer on at least one surface of the resistive film. More preferably, the barrier layer is provided on each surface of the resistive film.

Formation of the barrier layer on at least one surface of the resistive film can improve the durability in a high-temperature high-humidity environment, leading to the λ/4 type radio wave absorber having further excellent durability. Formation of the barrier layer on each surface of the resistive film can further improve the durability in a high-temperature high-humidity environment, leading to the λ/4 type radio wave absorber having furthermore excellent durability at once. The barrier layer is made of a metal compound like SiO₂, SiOₓ, Al₂O₃, MgAl₂O₄, CuO, CuN, TiO₂, TiN, and aluminum-doped zinc oxide (AZO). Namely, the material of the barrier layer preferably contains an oxide or nitride of silicon, titanium, or copper because the durability in a high-temperature high-humidity environment can be further improved. The barrier layer may be made of a single material or plural materials used in combination.

The barrier layer may have any thickness. Yet, the thickness is preferably 9 nm or less.

With the barrier layer having a thickness of 9 nm or less, the λ/4 type radio wave absorber can have further excellent durability in a high-temperature high-humidity environment. In view of further improving the durability in a high-temperature high-humidity environment, the upper limit of the thickness of the barrier layer is more preferably 8 nm, still more preferably 7 nm, further more preferably 6 nm, particularly preferably 5 nm, still further preferably 4 nm, significantly preferably 3.4 nm. Surprisingly, the thickness not exceeding the above upper limit was found to contribute to further improvement of the durability in a high-temperature high-humidity environment. The lower limit of the thickness of the barrier layer is not limited. In view of improving the durability in a high-temperature high-humidity environment, the lower limit of the thickness is preferably 0.3 nm, more preferably 0.5 nm, still more preferably 0.7 nm, particularly preferably 0.8 nm.

The thickness of the barrier layer can be measured by cross section measurement.

More specifically, the resistive film is first subjected to vapor deposition of carbon, and a cross section thereof is obtained using a FIB-SEM (Scios available from FEI Company, or its equivalent) . The thickness is measured from the cross section using a TEM (JEM-ARM200F available from Jeol Ltd., or its equivalent) at an accelerating voltage of 200 kV.

The λ/4 type radio wave absorber of the present invention may be produced by any method. In an exemplary method, a resistive film and a barrier layer are formed on a substrate made of polyethylene terephthalate or the like by ion plating, vapor deposition, sputtering or the like. On the resistive film or the barrier layer are laminated a dielectric layer and a reflective layer via an adhesive tape, thereby producing a λ/4 type radio wave absorber. It is to be noted that how to laminate each layer is not limited to use of an adhesive tape.

### - Advantageous Effects of Invention

The present invention can provide a λ/4 type radio wave absorber having excellent durability.

### DESCRIPTION OF EMBODIMENTS

Embodiments of the present invention are more specifically described in the following with reference to, but not limited to, examples.

### (Example 1)

A polyethylene terephthalate (PET) film having a thickness of 75 um was provided as a substrate. On the PET film was formed a resistive film having a thickness of 9.9 nm by DC pulsed sputtering. The sputtering was carried out using an alloy having a composition as shown in Table 1 as a target at an output of 0.4 kW with introduction of Ar gas at a flow rate of 100 sccm and at a pressure adjusted to 0.12 Pa. Next, on the formed resistive film was laminated a polycarbonate dielectric layer having a thickness of 300 um via an adhesive tape (707#4 available from Teraoka Seisakusho Co., Ltd., thickness of 30 µm). Further, on the dielectric layer was laminated an aluminum reflective layer having a thickness of 2 mm via an adhesive tape. Thus, a λ/4 type radio wave absorber was obtained.

The thickness of the resistive film was measured in the same manner as in the case of the barrier layer.

### (Example 2)

A polyethylene terephthalate (PET) film having a thickness of 75 µm was provided as a substrate. On the PET film was formed a barrier layer 1 having a thickness of 3.4 nm by DC pulsed sputtering using silicon as a target at an output of 1.0 kW with introduction of Ar gas at a flow rate of 100 sccm and oxygen gas at a flow rate of 10 sccm and at a pressure adjusted to 0.12 Pa. Next, on the barrier layer 1 was formed a resistive film having a thickness of 9.1 nm by DC pulsed sputtering. The sputtering was carried out using an alloy having a composition as shown in Table 1 as a target at an output of 0.4 kW with introduction of Ar gas at a flow rate of 100 sccm and at a pressure adjusted to 0.12 Pa. Then, on the resistive film were laminated a dielectric layer and a reflective layer in the same manner as in Example 1. Thus, a λ/4 type radio wave absorber was obtained.

### (Example 3)

A polyethylene terephthalate (PET) film having a thickness of 75 um was provided as a substrate. On the PET film was formed a resistive film having a thickness of 9.1 nm by DC pulsed sputtering. The sputtering was carried out using an alloy having a composition as shown in Table 1 as a target at an output of 0.4 kW with introduction of Ar gas at a flow rate of 100 sccm and at a pressure adjusted to 0.12 Pa. Next, on the resistive film was formed a silicon dioxide barrier layer 2 having a thickness of 2.2 nm by DC pulsed sputtering under the conditions of using silicon as a target at an output of 1.0 kW with introduction of Ar gas at a flow rate of 100 sccm and oxygen gas at a flow rate of 10 sccm and at a pressure of 0.12 Pa. Then, on the barrier layer 2 were laminated a dielectric layer and a reflective layer in the same manner as in Example 1. Thus, a λ/4 type radio wave absorber was obtained.

### (Example 4)

A polyethylene terephthalate (PET) film having a thickness of 75 µm was provided as a substrate. On the PET film was formed a barrier layer 1 having a thickness of 3.4 nm by DC pulsed sputtering under the conditions of using silicon as a target at an output of 1.0 kW with introduction of Ar gas at a flow rate of 100 sccm and oxygen gas at a flow rate of 10 sccm at a pressure of 0.12 Pa. Next, on the barrier layer 1 was formed a resistive film having a thickness of 9.2 nm by DC pulsed sputtering. The sputtering was carried out using an alloy having a composition as shown in Table 1 as a target at an output of 0.4 kW with introduction of Ar gas at a flow rate of 100 sccm and at a pressure adjusted to 0.12 Pa. Next, on the resistive film was formed a silicon dioxide barrier layer 2 having a thickness of 2.2 nm by DC pulsed sputtering under the conditions of using silicon as a target at an output of 1.0 kW with introduction of Ar gas at a flow rate of 100 sccm and oxygen gas at a flow rate of 10 sccm at a pressure of 0.12 Pa. Then, on the barrier layer 2 were laminated a dielectric layer and a reflective layer in the same manner as in Example 1. Thus, a λ/4 type radio wave absorber was obtained.

### (Examples 5 and 6)

A λ/4 type radio wave absorber was obtained in the same manner as in Example 4, except that the thicknesses of the resistive film and the barrier layers 1 and 2 were changed as shown in Table 1.

### (Example 7)

A λ/4 type radio wave absorber was obtained in the same manner as in Example 2, except that the thickness of the barrier layer 1 was changed as shown in Table 1.

### (Example 8)

A λ/4 type radio wave absorber was obtained in the same manner as in Example 3, except that the thickness of the barrier layer 2 was changed as shown in Table 1.

### (Examples 9 to 12)

A λ/4 type radio wave absorber was obtained in the same manner as in Example 4, except that the composition of the alloy used as a sputtering target and the thickness of the resistive film were changed as shown in Table 1.

### (Comparative Example 1)

A λ/4 type radio wave absorber was obtained in the same manner as in Example 1, except that the composition and the thickness of the resistive film were changed as shown in Table 1.

### (Comparative Example 2)

A λ/4 type radio wave absorber was obtained in the same manner as in Example 4, except that the composition and thickness of the resistive film and the thicknesses of the barrier layers 1 and 2 were changed as shown in Table 1.

### <Evaluation>

The λ/4 type radio wave absorbers obtained in the examples and comparative examples were evaluated by the following methods.

Table 1 shows the results.

### (Evaluation on electromagnetic wave absorption performance)

A PNA microwave network analyzer N5227A (available from Keysight Technologies), a PNA-X series 2-port millimeter-wave controller N5261A (available from Keysight Technologies), and a horn antenna FSS-07 (available from HVS Technologies, Inc.) were used to set up a radio wave absorption measuring device. Using this radio wave absorption measuring device, the radio wave absorption at W band (75 to 110 GHz) by the obtained λ/4 type radio wave/electromagnetic wave absorbers was measured in conformity with JIS R1679. The λ/4 type radio wave absorbers were set in such a manner that the radio wave was incident in a normal direction from the substrate side. The electromagnetic wave absorption performance was evaluated based on the obtained absorption amounts. Cases where the maximum radio wave absorption within the measurement range was 20 dB or more were rated A. Cases where the maximum radio wave absorption within the measurement range was less than 20 dB were rated B.

### (Evaluation on retention of electromagnetic wave absorption performance)

On each end of the resistive film in each of the examples and comparative examples was formed an electrode using silver paste. Between the electrodes were laminated a dielectric layer and a reflective layer in the same manner as in Example 1. Thus, a test λ/4 type radio wave absorber corresponding to each of the examples and comparative examples was prepared. The resistance value was measured after the preparation (resistance before a high-temperature high-humidity test). Next, the test λ/4 type radio wave absorber was subjected to a high-temperature high-humidity test in which the test λ/4 type radio wave absorber is left to stand at a temperature of 85°C and a humidity of 85% for 500 hours. Then, the resistance was measured. The change rate (resistance after the test/resistance before the test) of the resistance before and after the test was calculated from the obtained resistance values, and the retention of the electromagnetic wave absorption performance was evaluated.

**[Table 1]**

| | | | Example | | | | | | | | | | | | Comparative Example | |
|---|---|---|---|---|---|---|---|---|---|---|---|---|---|---|---|---|
| | | | 1 | 2 | 3 | 4 | 5 | 6 | 7 | 8 | 9 | 10 | 11 | 12 | 1 | 2 |
| Resistive film | Composition (wt%) | Mo | 16.4 | 16.4 | 16.4 | 16.4 | 16.4 | 16.4 | 16.4 | 16.4 | 5.5 | 28.0 | 13.0 | 9.0 | - | - |
| | | Ni | 51.2 | 51.2 | 51.2 | 51.2 | 51.2 | 51.2 | 51.2 | 51.2 | 43.0 | 68.5 | 56.0 | 47.0 | 87.2 | 87.2 |
| | | Cr | 17.5 | 17.5 | 17.5 | 17.5 | 17.5 | 17.5 | 17.5 | 17.5 | 30.0 | 1.0 | 22.0 | 22.0 | 8.9 | 8.9 |
| | | Fe | 11.1 | 11.1 | 11.1 | 11.1 | 11.1 | 11.1 | 11.1 | 11.1 | 15.0 | 1.0 | 3.0 | 18.0 | 3.9 | 3.9 |
| | | W | 3.2 | 3.2 | 3.2 | 3.2 | 3.2 | 3.2 | 3.2 | 3.2 | 2.5 | - | 3.0 | 0.5 | - | - |
| | | Mn | - | - | - | - | - | - | - | - | 1.5 | 0.5 | 0.5 | 1.0 | - | - |
| | | Co | - | - | - | - | - | - | - | - | 2.0 | 0.5 | 2.4 | 1.5 | | |
| | | Si | 0.6 | 0.6 | 0.6 | 0.6 | 0.6 | 0.6 | 0.6 | 0.6 | 0.5 | 0.5 | 0.1 | 1.0 | - | - |
| | Thickness (nm) | | 10.7 | 9.8 | 9.8 | 10.0 | 10.5 | 9.8 | 9.8 | 9.8 | 10.1 | 9.9 | 10.3 | 10.1 | 7.3 | 7.3 |
| Barrier layer 1 | Composition | | - | SiO₂ | - | SiO₂ | SiO₂ | SiO₂ | SiO₂ | - | SiO₂ | SiO₂ | SiO₂ | SiO₂ | - | SiO₂ |
| | Thickness (nm) | | - | 3.4 | - | 3.4 | 0.8 | 9.3 | 9.3 | - | 3.4 | 3.4 | 3.4 | 3.4 | - | 3.2 |
| Barrier layer 2 | Composition | | - | - | SiO₂ | SiO₂ | SiO₂ | SiO₂ | - | SiO₂ | SiO₂ | SiO₂ | SiO₂ | SiO₂ | - | SiO₂ |
| | Thickness (nm) | | - | - | 2.2 | 2.2 | 0.8 | 9.3 | - | 9.3 | 2.2 | 2.2 | 2.2 | 2.2 | - | 3.2 |
| Reflective laye, | Composition | | Al | | | | | | | | | | | | | |
| | Thickness (mm) | | 2 | | | | | | | | | | | | | |
| Evaluation | Electromagnetic wave absorption performance | | A | A | A | A | A | B | B | B | A | A | A | A | A | A |
| | Retention of electromagnetic wave absorption performance (Change rate, %) | | 2.24 | 1.35 | 1.35 | 1.19 | 1.43 | 1.79 | 2.01 | 1.94 | 1.72 | 1.69 | 1.14 | 1.45 | ∞ | ∞ |

### INDUSTRIAL APPLICABILITY

The present invention can provide a λ/4 type radio wave absorber having excellent durability.

## Claims

1. A λ/4 type radio wave absorber comprising:
a resistive film comprising a barrier layer containing an oxide or nitride of silicon, titanium, or copper on at least one surface;
a dielectric layer; and
a reflective layer, in the stated order,
**characterized in that**
the resistive film contains molybdenum in an amount of 30% by weight or lower.

2. The λ/4 type radio wave absorber according to claim 1,
wherein the barrier layer has a thickness of 9 nm or less.

3. The λ/4 type radio wave absorber according to any one of claims 1 or 2,
wherein the resistive film further contains nickel and chromium.

4. The λ/4 type radio wave absorber according to claim 3,
wherein the resistive film contains molybdenum in an amount of 5% by weight or more, nickel in an amount of 40% by weight or more, and chromium in an amount of 1% by weight or more.

## Patentansprüche

1. Funkwellenabsorber vom λ/4-Typ, umfassend:
einen Widerstandsfilm, umfassend eine Sperrschicht, die ein Oxid oder Nitrid von Silizium, Titan oder Kupfer an zumindest einer Oberfläche enthält,
eine dielektrische Schicht, und
eine reflexive Schicht, in der angegebenen Reihenfolge,
**dadurch gekennzeichnet, dass**
der Widerstandsfilm Molybdän in einer Menge von 30 Gew.-% oder weniger enthält.

2. Funkwellenabsorber vom λ/4-Typ nach Anspruch 1,
wobei die Sperrschicht eine Dicke von 9 nm oder weniger aufweist.

3. Funkwellenabsorber vom λ/4-Typ nach einem der Ansprüche 1 oder 2,
wobei der Widerstandsfilm ferner Nickel und Chrom enthält.

4. Funkwellenabsorber vom λ/4-Typ nach Anspruch 3,
wobei der Widerstandsfilm Molybdän in einer Menge von 5 Gew.-% oder mehr, Nickel in einer Menge von 40 Gew.-% oder mehr, und Chrom in einer Menge von 1 Gew.-% oder mehr enthält.

## Revendications

1. Absorbeur d'ondes radio de type λ/4 comprenant :
un film résistif comprenant une couche de barrière contenant un oxyde ou nitrure de silicium, titane ou cuivre sur au moins une surface ;
une couche diélectrique ; et
une couche réfléchissante, dans l'ordre indiqué,
**caractérisé en ce que**
le film résistif contient du molybdène en une quantité de 30 % en poids ou moins.

2. Absorbeur d'ondes radio de type λ/4 selon la revendication 1, dans lequel la couche de barrière a une épaisseur de 9 nm ou moins.

3. Absorbeur d'ondes radio de type λ/4 selon l'une quelconque des revendications 1 et 2, dans lequel le film résistif contient en outre du nickel et du chrome.

4. Absorbeur d'ondes radio de type λ/4 selon la revendication 3, dans lequel le film résistif contient du molybdène en une quantité de 5 % en poids ou plus, du nickel en une quantité de 40 % en poids ou plus, et du chrome en une quantité de 1 % en poids ou plus.
